# EUROPEAN PATENT APPLICATION

(11) **EP 0 797 360 A2**
(43) Date of publication of application: **24.09.1997**
(21) Application number: 97301682.7
(22) Date of filing: 13.03.1997
(51) Int. Cl.: H04N 7/30

(54) **Method for calculating bit length of code word and variable length code table applied to the method therefor**

(30) Priority: 22.03.1996 KR 9607943
(71) Applicant: LG ELECTRONICS INC., Seoul (KR)
(72) Inventor: Kim, Su Hwan, Seodaemun-ku, Seoul (KR); Bae, Seong Ok, Uiwang-si, Kyungki-do (KR)
(74) Representative: Cross, Rupert Edward Blount

(57) **Abstract**

Improved method for calculating a bit length of a code word and a variable length code table applicable to the same are suggested, in which all possible code words are taken into account, all the possible code words are classified into a plurality of classes of statistically similar code words of the same lengths, these classes together with bit lengths thereof are stored in a table, and a bit length corresponding to a class of a code word provided to the table is produced from the table, whereby a bit length corresponding to a code word provided to the table can be searched faster because the bit lengths are stored in the table as classified.

## Description

### BACKGROUND OF THE INVENTION

### Field of the Invention

The present invention relates to a method for calculating a bit length of a code word and a variable length code table applicable to the method therefor.

### Discussion of the Related Art

In general, the VLC(Variable Length Code) called sometimes as the Hoffmann code, being a lossless coding method, is one of the optimization code having the statistical characteristics of a data applied thereto. In the application of the statistical characteristics of a data, the shorter code word is designated, the more frequent video data are generated, and the longer code word is designated, the less frequent video data are generated. If code words are designated to all possible video data applying such a method thereto, an average bit length of code words can be compressed shorter than an originally intended average bit length.

This VLC is employed in systems which require a technique for compressing a video data, such as MPEG 1(Moving Picture Expert Group 1), MPEG 2(Moving Picture Expert Group 2) and HDTV(High Definition Television) for reproducing video data and implementing advanced picture quality. However, as one of the means for complementing the requirement for a faster speed decoder required for implementing such a video data compressing technique, interests are focused on techniques which can decode a code word length of video data faster than ever.

According to the known arts up to now, upon reception of an encoded data(or a code word) processed by a fast data processor, a random variable length code table produces a decoded data(code word) and a bit length of this decoded code word. The conventional random variable length code table consists of numerous number of combinations of logic gates. It takes a lot of times in calculating a bit length of a code word decoded applying the random variable length code table which consists of such numerous logic gates thereto. That is, upon reception of a code word pursuant to the MPEG standard, the random variable length code table executes a lot of loops continuously until the numerous logic gates satisfy the processing conditions for determining the code word length. Accordingly, a substantial amount of time is required.

As discussed, the lengthy processing time required for decoding an encoded code word and calculating a length ofthe decoded code word ofthe random variable length code table causes a problem that the processing speed of the decoder becomes slow resulting in degradation of the picture quality.

### SUMMARY OF THE INVENTION

Embodiments of the present invention are directed to method for calculating a bit length of a code word and a variable length code table applied to the method therefor that substantially obviates one or more of the problems due to limitations and disadvantages of the related art. In one preferred embodiment there is provided a method for calculating a bit length of a received code word in decoding and a variable length code table applicable to the method.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

According to a first aspect of the present invention there is provided a method for calculating a bit length of a code word comprising the steps of classifying all possible code words into a plurality of classes of statistically similar code words of the same length, storing the plurality of classes together with bit lengths thereof in a table, and producing a bit length corresponding to a class of a code word provided to the table from the table.

In other aspect of the present invention, there is provided a variable length code table including a decoding table for producing a decoded code word corresponding to a received code word in response to the received code word, a selecting signal generating part for providing a length selecting signal in response to the received code word, a class part having a plurality of classes each having statistically similar code words of the same length, and a selecting part for selecting a bit length as a bit length of the received code word from a plurality of bit lengths provided from the class part in response to the length selecting signal.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the drawings:

In the drawings:
Fig. 1 illustrates a system of a variable length code table in accordance with a preferred embodiment of the present invention;
Fig. 2 illustrates an intermediate unit of the variable length code table of Fig. 1;
Fig. 3 illustrates a table showing classification of all possible code words into classes of statistically similar code words of the same length in accordance with an embodiment of the present invention; and,
Fig. 4 illustrates a flow chart showing an outline of the steps of a method for calculating a bit length of a code word in accordance with an embodiment of the present invention.

### DETAILED DESCRIPTION OF THE PREFERRED EMBODIMENT

Reference will now be made in detail to the preferred embodiments of the present invention, examples of which are illustrated in the accompanying drawings.

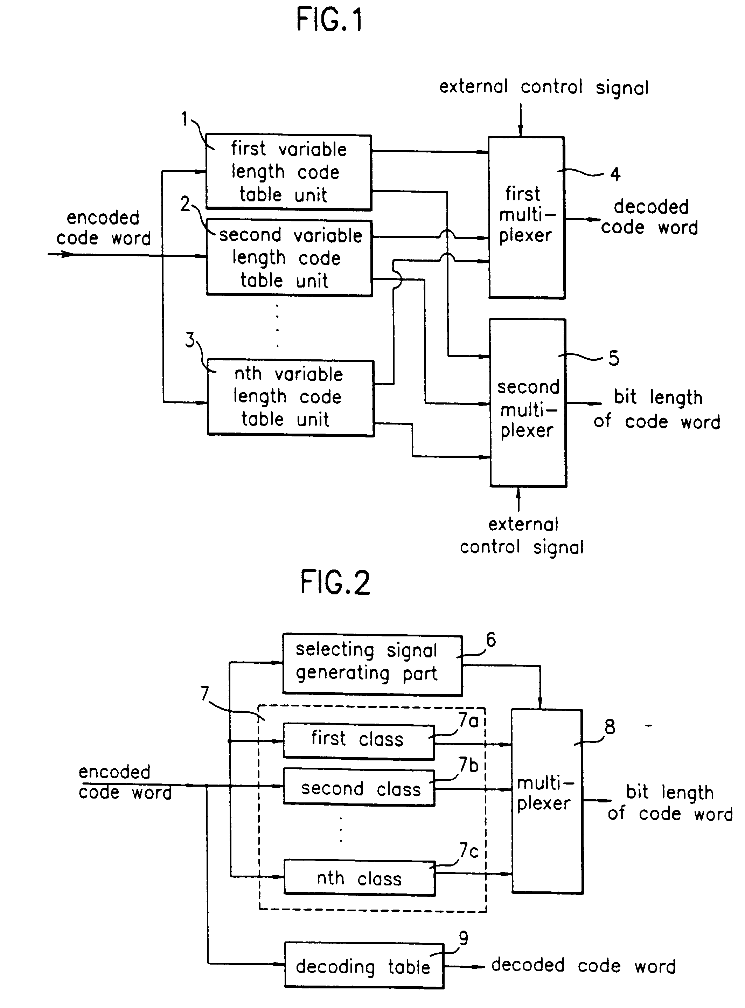

Fig. 1 illustrates an outline of an optimal system of a variable length code table in accordance with a preferred embodiment of the present invention.

Referring to Fig. 1, the variable length code table includes a plurality of variable length code table units 1, 2 and 3 each for producing a decoded code word relevant to a received code word in response to the received code word and a bit length of the code word, a first multiplexer 4 acting as a selecting part for selecting one as the decoded code word of the received code word from the decoded code words received from the plurality of variable length code tables 1, 2 and 3 in response to an external first selecting signal, and a second multiplexer 5 acting as a selecting part for selecting one as a bit length of the received code word from the bit lengths received from the plurality of variable length code tables 1, 2 and 3 in response to an external second selecting signal. The aforementioned code words and decoded code words may be of the MPEG standard or other standards.

Fig. 2 illustrates a detail of the variable length code table unit in Fig. 1.

Referring to Fig. 2, the variable length code table unit includes a selecting signal generating part 6 for providing a length selecting signal in response to an encoded code word(or a data) received from a fast data processor, a class part 7 having a plurality of classes 7a, 7b and 7c each for receiving the encoded code word and providing a bit length of the encoded code word, a multiplexer 8 acting as a selecting part for selecting a bit length of a relevant class from the plurality of classes 7a, 7b and 7c in response to the selecting signal from the selecting signal generating part 6, and a decoding table 9 for producing a decoded code word corresponding to the received code word. The aforementioned code words and decoded code words may be of the MPEG standard or other standards, and each of the classes includes code words having, not only statistically similar bits, but also the same bit lengths.

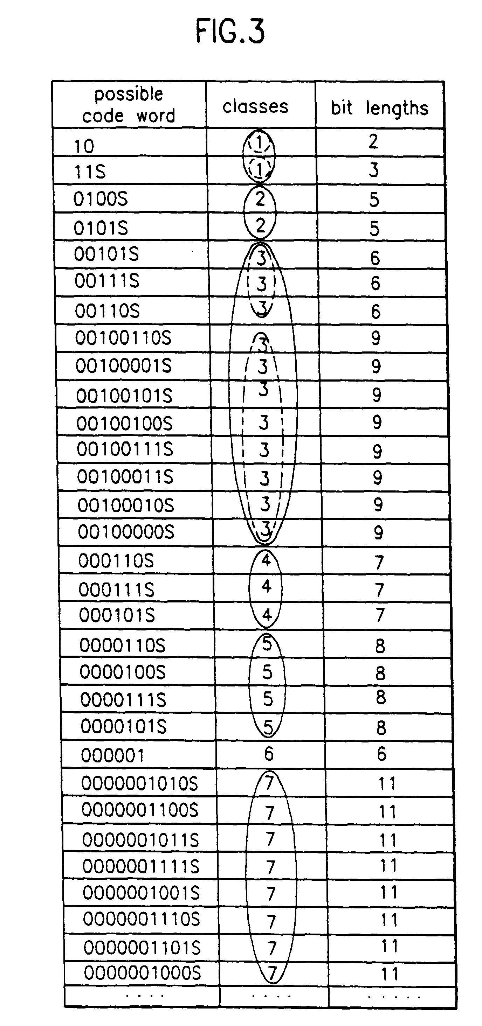

These classes are classed and set in advance in fabrication ofthe variable length code table. The steps for setting the classes will be explained with reference to the table shown in Fig. 3.

First, all code words which may be possibly generated are taken into account. All these possible code words are classified into statistically similar code words of the same lengths. The word of "statistically similar code words" denotes that the code words has at least one identical bit(or bits). Accordingly, all the possible code words may be classified into a plurality of classes. As explained, the code words included in each of the classes have at least one identical bit(or bits) in common and the same bit lengths. In the steps of the classification, firstly at least one forward bits of all the possible code words are compared. Accordingly, all the possible code words are classified into a plurality of preliminary classes of code words having one or more than one identical forward bits at first. Then, secondly bit lengths of the code words in each of the preliminary classes are compared. Accordingly, all the possible code words are classified into the plurality of classes of code words having, not only the same bit lengths, but also at least one or more than one identical forward bits. The plurality of classes classified thus completely are stored into the class part 7 in each of the variable length code table units in advance.

The operation of the variable code length table in accordance with a preferred embodiment of the present invention will now be explained in detail with reference to Figs. 1 ∼ 4.

Upon reception of encoded code words with certain numbers of bits in a form of a bit stream, the variable length code table shown in Fig. 1 processes the code words according to the MPEG standard to produce decoded code words and bit lengths of the decoded code words. As explained, the signal processing step for calculating the bit lengths includes the step of searching the plurality of classes 7a, 7b and 7c classified into classes of statistically similar code words according to the MPEG standard for a class corresponding to the received code word. As shown in Fig. 1, the variable length code table has at least one or more than one variable length code table units, such as a table for use in obtaining a decoded code word of the MPEG standard and a table for use in correcting a motion of an image. Accordingly, each of the variable length code table units produces corresponding bit length and decoded code word in response to a received code word, and the first multiplexer 4 and the second multiplexer 5 select desired bit length and decoded code word in response to an external control signal, respectively. Thus, a certain one of the decoded code words from the variable length code table units 1, 2 and 3 selected by the first multiplexer 4 so as to meet the purpose of the present process in response to an external signal, and alikely the bit length of the selected code word is selected by the second multiplexer 5.

The variable length code table will be explained in more detail hereinafter.

Referring to Fig. 2, when the variable length code table unit receives an encoded code word, the class part produces a plurality of bit lengths in response to reception of the encoded code word. As explained, the class part 7 has a plurality of classes, and each of the classes has statistically similar code words of the MPEG or other standard. As shown in Fig. 3, each of the classes in the class parts 7 produces a corresponding bit length of a code word in response to reception of the code word at the variable length code table unit. For example, the code words in the classes 3, 4 and 5 partly have identical forward bits of 001, 0001 and 00001, respectively. Therefore, by only detecting the partly identical forward bits, the bit length of a received code word can be calculated with easy. And, the selecting signal generating part 6 in Fig. 2 produces a corresponding selecting signal in response to reception of the code word, which is the encoded data. The selecting signal is applied to the multiplexer 8 as a control signal, thereby selects one of the plurality(or 'n' numbers, where the 'n' is a positive integer) of the bit lengths from the class part 7. Herein, the selected one is a bit length of the class corresponding to the received code word. Therefore, the multiplexers 4, 5 and 8 are n x 1 multiplexers. By obtaining a bit length of a received code word with the aforementioned method, the decoding speed of a variable length code decoder can be improved.

In the meantime, while producing a bit length of a received code word, each of the variable length code table units processes an encoded code word of the MPEG standard at random by means of a decoding table 9 having a plurality of random logic gates, for decoding the encoded code word. Thus, a decoded code word corresponding to the received code word can be obtained. And, the variable length code table shown in Fig. 1 receives and processes the bits of the received code word in parallel for speeding up the decoding speed.

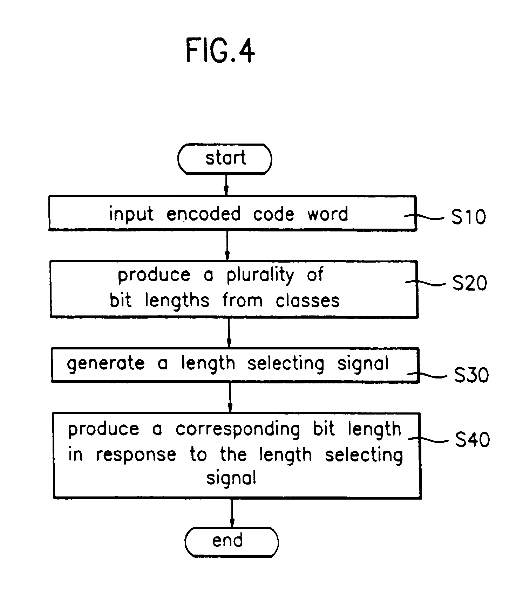

Fig. 4 illustrates a flow chart showing an outline of the steps of a method for calculating a bit length of a code word encoded by the system shown in Fig. 2.

Referring to Fig. 4, when a code word, which is an encoded data, is received at each of the variable length code table units 1, 2 and 3(S10), each of a plurality of classes of code words classified into similar code words according to a statistical characteristic of the MPEG standard searches for at least one or more than one bits of the received code word and produces a preset bit length(S20). During each of the classes produces a corresponding bit length, the selecting signal generating part 6 processes the received code word by means of internal combination logics, to produce a length selecting signal(S30). The length selecting signal thus produced is applied to the multiplexer 8, to select a bit length of a corresponding class from the plurality of bit lengths from the class part 7(S40).

As has been explained, according to the method for calculating a bit length of a code word and a variable length code table applied to the method can calculate a bit length of a code word in decoding the code word, whereby a real time fast speed decoding of an image data of the MPEG standard is facilitated. And, since a sufficient allowance for a decoding speed is secured, data can be transmitted at a faster speed. The aforementioned two advantages facilitate realization of an advanced resolution.

It will be apparent to those skilled in the art that various modifications and variations can be made in a method for calculating a bit length of a code word and a variable length code table applicable to the method therefor of the present invention without departing from the scope of the invention. Thus, it is intended that the present invention cover the modifications and variations of this invention provided they come within the scope of the appended claims and their equivalents.

## Claims

1. A method for calculating a bit length of a code word comprising the steps of:
(1) classifying all possible code words into a plurality of classes of statistically similar code words of the same lengths;
(2) storing the plurality of classes together with bit lengths thereof in a table; and,
(3) producing a bit length corresponding to a class of a code word provided to the table from the table.

2. A method as claimed in claim 1, wherein the code words are of the MPEG standard.

3. A method as claimed in claim 1, wherein the (1) step includes the step of,
comparing at least one or more than one forward bits of all the possible code words at classifying all the possible code words into a plurality of preliminary classes of code words having one or more than one identical forward bits, and
comparing bit lengths of the code words in each of the preliminary classes at classifying all the possible code words into the plurality of classes of code words having, not only the same bit lengths, but also at least one or more than one identical forward bits.

4. A method for calculating a bit length of a code word comprising the steps of:
(1) classifying all possible code words into a plurality of classes of code words having, not only statistically similar, but also the same lengths;
(2) storing the plurality of classes together with bit lengths thereof in a table;
(3) obtaining a length selecting signal corresponding to an encoded code word provided to the table using the encoded code word;
(4) producing a certain one of a plurality of bit lengths provided from the plurality of classes as a bit length of the code word from the table in response to the length selecting signal.

5. A method as claimed in claim 4, wherein the code word provided to the table is of the MPEG standard.

6. A method as claimed in claim 4, wherein the (1) step includes,
comparing at least one or more than one forward bits of all the possible code words at classifying all the possible code words into a plurality of preliminary classes of code words having one or more than one identical forward bits, and
comparing bit lengths of the code words in each of the preliminary classes at classifying all the possible code words into the plurality of classes of code words having, not only the same bit lengths, but also at least one or more than one identical forward bits.

7. A variable length code table comprising:
a decoding table for producing a corresponding decoded code word in response to a received code word;
a selecting signal generating part for providing a length selecting signal in response to the received code word;
a class part including a plurality of classes each having statistically similar code words of the same bit lengths; and,
a selecting part for selecting one as a bit length of the received code word from a plurality of bit lengths provided from the class part in response to the length selecting signal.

8. A variable length code table as claimed in claim 7, wherein the code words are of the MPEG standard.

9. A variable length code table as claimed in claim 7, wherein the code words included in each of the classes have at least one or more than one identical forward bits.

10. A variable length code table as claimed in claim 7, wherein the decoding table includes a plurality of random gates.

11. A variable length code table as claimed in claim 7, wherein the variable length code table receives and processes bits of the received code word in parallel.

12. A variable length code table as claimed in claim 7, wherein the selecting part is an n x 1 multiplexer, where the 'n' is a positive integer.

13. A variable length code table comprising:
a plurality of variable length code tables each including, a decoding table for producing a decoded code word in response to a received code word, a selecting signal generating part for providing a length selecting signal in response to the received code word, a plurality of classes each having statistically similar code words ofthe same bit lengths, and a length selecting part for selecting one as a bit length of the received code word from a plurality of bit lengths provided from the classes in response to the length selecting signal;
a first selecting part for selecting a certain one from the decoded code words received from the variable length code table units in response to an external first selecting signal; and,
a second selecting part for selecting a certain one from the bit lengths received from the variable length code table units in response to an external second selecting signal.

14. A variable length code table as claimed in claim 13, wherein the code words are of the MPEG standard.

15. A variable length code table as claimed in claim 13, wherein all the first, second and length selecting parts are n x 1 multiplexers, where the 'n' is a positive integer.

16. A variable length code table as claimed in claim 13, wherein the code words included in each of the classes include at least one or more than one identical forward bits.

17. A variable length code table as claimed in claim 13, wherein each of the decoding table includes a plurality of random gates.

18. A variable length code table as claimed in claim 13, wherein the variable length code table receives and processes bits of code word inputs in parallel.
